(19) Europäisches Patentamt
European Patent Office
Office européen des brevets

(11) **EP 4 166 961 B1**

(12) **EUROPEAN PATENT SPECIFICATION**

(45) Date of publication and mention
of the grant of the patent:
**21.02.2024 Bulletin 2024/08**

(51) International Patent Classification (IPC):
**G01R 31/367** (2019.01)   **G01R 31/3842** (2019.01)

(52) Cooperative Patent Classification (CPC):
**G01R 31/367; G01R 31/3842;** Y02E 60/10

(21) Application number: **22195407.6**

(22) Date of filing: **11.10.2021**

(54) **BATTERY STATE ESTIMATION METHOD**

BATTERIEZUSTANDSSCHÄTZUNGSVERFAHREN

PROCÉDÉ D'ESTIMATION D'ÉTAT DE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**19.04.2023 Bulletin 2023/16**

(62) Document number(s) of the earlier application(s) in accordance with Art. 76 EPC:
**21201990.5 / 4 163 654**

(73) Proprietor: **TWAICE Technologies GmbH**
**80807 München (DE)**

(72) Inventors:
• **KONDAVALASA, Saiveer Patnaik**
**97080 Würzburg (DE)**
• **ATUKALP, Devin**
**81735 München (DE)**
• **MAHESHWARI, Arpit**
**81371 München (DE)**

(74) Representative: **Kraus & Lederer PartGmbB**
**Thomas-Wimmer-Ring 15**
**80539 München (DE)**

(56) References cited:
**US-A1- 2016 016 482**

• **DONG GUANGZHONG ET AL: "Sequential Monte Carlo Filter for State-of-Charge Estimation of Lithium-Ion Batteries Based on Auto Regressive Exogenous Model", IEEE TRANSACTIONS ON INDUSTRIAL ELECTRONICS, IEEE SERVICE CENTER, PISCATAWAY, NJ, USA, vol. 66, no. 11, 1 November 2019 (2019-11-01), pages 8533-8544, XP011733258, ISSN: 0278-0046, DOI: 10.1109/TIE.2018.2890499 [retrieved on 2019-07-01]**

## Description

The present invention relates to a method and an apparatus for estimating a state of a battery, for instance the state of charge and/or the state of health of a battery.

## Background

Batteries are finding more and more applications in everyday use. To ensure that batteries are properly used, which is crucial in extracting the maximum performances and prolonging their life, battery analysis and management is becoming more and more crucial.

In particular, the state of health (SoH) and state of charge (SoC) of a battery are among the most important indicator of a battery system.

Various manners are known in the art for measuring and/or estimating SoH and SoC, and are mostly based on creating a battery model, measuring parameters of the battery, and populating the model with those parameters. Those models, which can be equivalent electric circuits or physical models, however generally need to be created for each given battery, by testing and parametrizing the battery in the lab. The results of the tests are then used to populate the model, which can be later used to estimate the SoH and SoC.

Due to the ever increasing number of different batteries, owing to various chemistry, capacity, electrode materials, etc. it becomes challenging to test all possible batteries. Even if possible, such mass testing requires a large amount of time and financial, as well as technical, resources.

It is therefore desirable to provide a manner for estimating a state of a battery, such as the SoC and/or SoH, without requiring a specific model of the given battery.

Methods for measuring and/or estimating SoH and SoC are known in the art for instance from documents US 2016/016482 A1 and DONG GUANGZHONG ET AL: "Sequential Monte Carlo Filter for State-of-Charge Estimation of Lithium-Ion Batteries Based on Auto Regressive Exogenous Model", IEEE TRANSACTIONS ON INDUSTRIAL ELECTRONICS, IEEE SERVICE CENTER, PISCATAWAY, NJ, USA, vol. 66, no. 11, 1 November 2019.

## Summary of the invention

The present invention is generally based on the concept that parameters of a battery can be measured from voltage and/or current measurement taken while the battery is being used, instead of requiring extensive testing the battery in the lab. From those parameters, a model of the battery can be built, which can then be used for estimating the state of the battery.

An embodiment can in particular relate to a method for estimating a state of a battery, the method comprising the steps of: acquiring data of the battery during at least a predetermined time range, the data comprising at least a plurality of voltage measurements and a plurality of current measurements, determining a time window within the predetermined time range, the time window starting after a relaxed voltage interval and comprising a dynamic load interval, executing a subspace identification analysis within the time window resulting in the determination of one or more parameters of the battery, populating a model of the battery with the one or more parameters, estimating the state of the battery based on the model.

Thanks to this approach, the model of the battery can be populated based on voltage and current measurements taken during the battery operation, without requiring extensive analysis and/or characterization of the battery in a laboratory. In addition to avoiding the costs associated with the laboratory analysis, this also allows the method to be executed on batteries which are already installed.

In some embodiments, the one or more parameters can comprise one or more time constants of one or more respective RC components of the model.

In some embodiments, the one or more parameters can comprise one or more resistance values of one or more respective RC components of the model and/or an ohmic resistance value of the model.

In some embodiments, the one or more parameters can comprise one or more capacitance values of one or more respective RC components of the model.

Thanks to those parameters, it is possible to build a model of the battery which allows subsequent estimation of the status of the battery based only on the voltage and/or current measurements from the battery, without requiring any further characterization of the battery and/or without requiring further constraints on how or when the battery voltage and/or current are measured.

In some embodiments, the one or more parameters can expressed as a function of the state of the battery.

Thanks to this, it is possible to build the model as a look-up table for a number of values of a state of the battery, for instance for a number of values for the state of charge of the battery. By later using current and/or voltage measurement as inputs into the model, the respective value for the state of the battery can be determined.

In some embodiments, at least the step of executing the subspace identification analysis can be executed a plurality of time, for a plurality of different values of the state of charge of the battery, and the step of populating the model of the battery can comprise populating a look-up table as a function of the different values of the state of charge.

Thanks to this implementation, the implementation of the look-up table can be executed in a simple and yet reliable manner, requiring only voltage and/or current measurements from the battery.

The method further comprises a step of executing a Kalman filter on the model of the battery.

Thanks to this implementation, potential errors introduced by noise and/or measuring imprecisions can be corrected, rendering the model of the battery more precise.

A further embodiment can relate to an apparatus for estimating a state of a battery, the apparatus comprising a memory and a processor, wherein the memory comprises instructions configured to, when executed, cause the processor to carry out any of the steps described.

In some embodiments, the apparatus can further comprise communication means for obtaining the plurality of voltage measurements and the plurality of current measurements.

Thanks to this implementation, it is possible to implement the apparatus in a location different from the battery location and thus allow the model of the battery to be populated and/or operated remotely, simply requiring standard voltage and/or current measurements at the battery site.

A further embodiment can relate to a software which, when executed on a processor, can cause the processor to carry out any of the steps described.

## Brief description of the drawings

In the followings, aspects of the invention will be described with reference to the drawings, in which like reference numerals indicate like elements, and in which:

figure 1 schematically illustrates a method 1000 for estimating a state of a battery;

figure 2 schematically illustrates an apparatus 2000 for estimating a state of a battery;

figure 3A schematically illustrates an exemplary voltage measurement over time;

figure 3B schematically illustrates an exemplary current measurement over time;

figure 4 schematically illustrates a possible implementation of a dynamic voltage determination step S4400;

figure 5 schematically illustrates an exemplary model 5000 of a battery;

figure 6A schematically illustrates an exemplary state of charge over time;

figure 6B schematically illustrates an exemplary open circuit voltage over time;

figure 7A schematically illustrates an exemplary voltage measurement over time;

figure 7B schematically illustrates an exemplary dynamic voltage over time.

## Detailed description of preferred embodiments

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

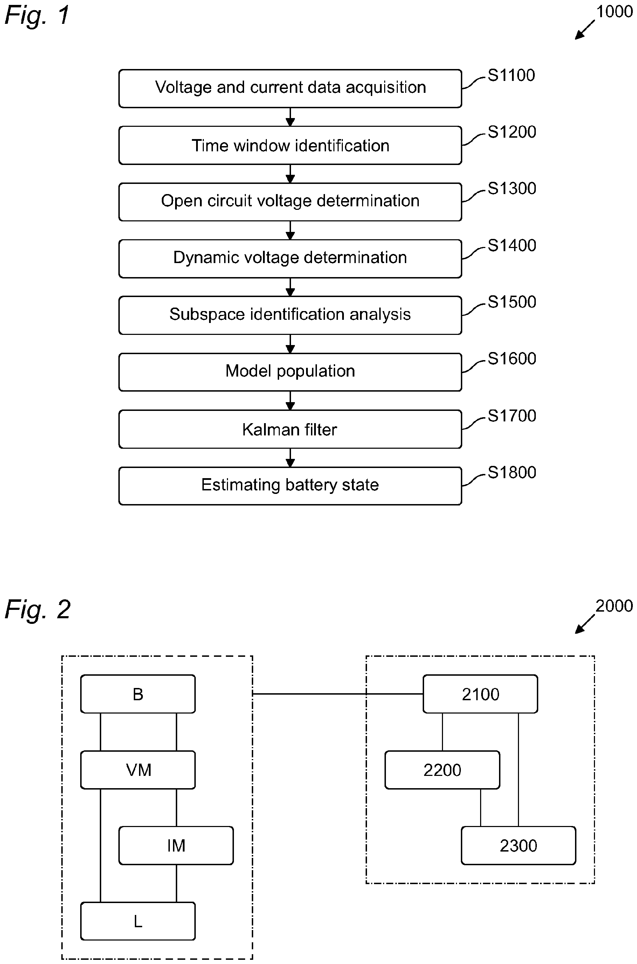

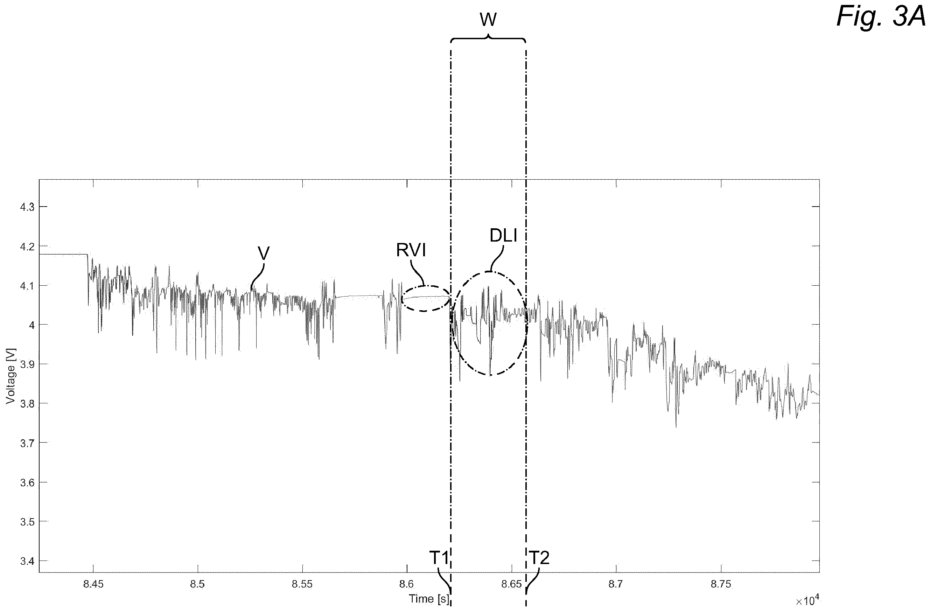

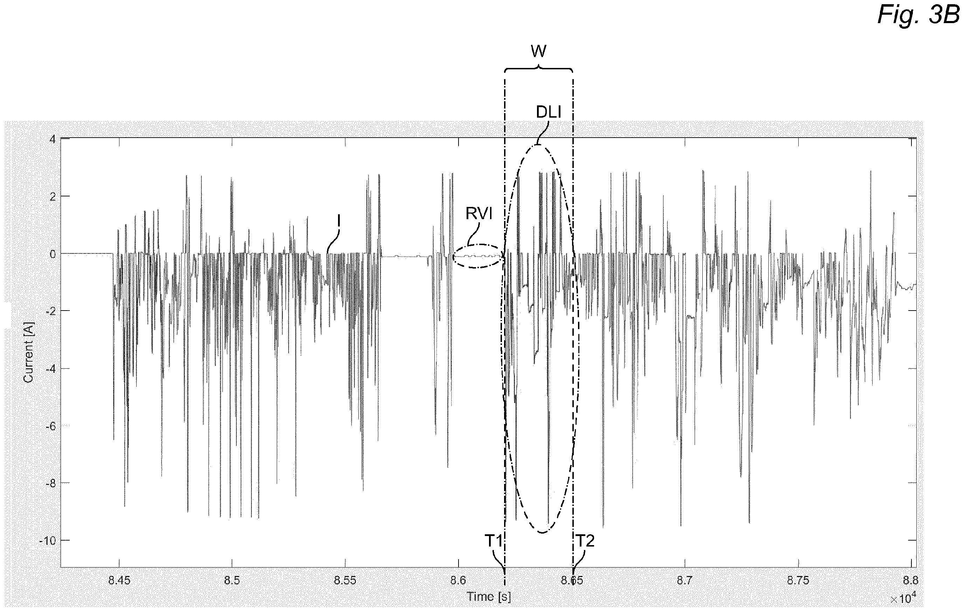

Figure 1 schematically illustrates a method 1000 for estimating a state of a battery B. In the context of the application, by state of the battery can be intended, unless otherwise specified, the state of charge, SoC, and/or the state of health, SoH. The method comprises a step S1100 of acquiring data of the battery B during at least a predetermined time range, the data comprising at least a plurality of voltage measurements and a plurality of current measurements. Example voltage measurements are visible in figure 3A while example current measurements are visible in figure 3B. In some embodiments, the measurements are preferably sampled with at least the Nyquist frequency of the respective signals.

The method 1000 further comprises a step S1200 of determining a time window W within the predetermined time range, the time window W starting after a relaxed voltage interval RVI of the battery and comprising a dynamic load interval DLI of the battery. In some preferred embodiments, the time window W starts immediately after an end of the relaxed voltage interval RVI. In other words, the end time of the relaxed voltage interval RVI can correspond to the start time of the time window W. In some preferred embodiments, the time window W starts within a predetermined time after an end of the relaxed voltage interval RVI. The predetermined time can preferably be less than 1 minute. Alternatively, or in addition, the predetermined time can be determined so that the state of charge of the battery does not significantly change during the predetermined time.

In general, it will be clear that in general the dynamic load interval DLI can start at any point after a relaxed voltage interval RVI. The relaxed voltage interval RVI can be used to reliably measure the open circuit voltage and thus reliably derive a state of charge of the battery. The state of charge of can then be tracked for any amount of time, in particular at least until the beginning of relaxed voltage interval RVI, so as to provide an initial state of charge, and thus an initial open circuit voltage, of the relaxed voltage interval RVI. The choice of a dynamic load interval DLI close, or immediately after, a relaxed voltage interval RVI provides at least the advantage that the tracking of the state of charge can be reduced or avoided entirely.

The relaxed voltage interval RVI is generally a time interval in which the battery is not under significant charge and/or discharge, as known to the skilled person, preferably under no charge and/or discharge, even more preferably for a time sufficient for the open circuit voltage to stabilize. In some embodiments, the relaxed voltage interval RVI can thus be determined to be a time interval during which the voltage is stable within a predetermined range, for at least a predetermined time duration. Alternatively, or in addition, in some embodiments, the relaxed voltage interval RVI can be determined to be a time interval during which the absolute value of the current is lower than a predetermined threshold, for at least a predetermined time duration. In preferred embodiments, the time interval can be at least 1 minute, preferably at least 5 minutes.

The dynamic load interval DLI is generally a time interval comprising charging and/or discharging of the battery, preferably both charging and discharging. In some embodiments, the dynamic load interval DLI can thus be determined to be a time interval during which the voltage is varying outside of a predetermined range, for at least a predetermined time duration. Alternatively, or in addition, in some embodiments, the dynamic load interval DLI can be determined to be a time interval during which the absolute value of the current is higher than a predetermined threshold, for at least a predetermined time duration. It will be appreciated that the numerical values for those ranges, thresholds and time durations are dependent on the characteristics of the battery, such as technology, capacity, voltage and maximum rated output current, and it will be clear to the skilled person how to identify a relaxed voltage interval RLG and a dynamic load interval DLI for a given specific battery.

In some embodiments, the dynamic load interval DLI can be defined as a time interval during which one or more of the following conditions apply.

One condition for identifying the dynamic load interval DLI can be if a value of an integral of an absolute value of the current measurements I is within a predetermined range. That is, an absolute value of the current measurements I can be integrated over the time interval and, if the result is within a predetermined range, the time interval can be considered to be a dynamic load interval DLI. In some embodiments, the predetermined range can be higher than 1% of the capacity of the battery B, and/or preferably lower than 5% of the capacity of the battery B, and/or even more preferably lower than 2.5% of the capacity of the battery B.

Thanks to the upper limitation on the integral of the absolute value of the current measurements I, it can be advantageously ensured that the variation of open circuit voltage, throughout the dynamic load interval DLI, is contained.

One further condition for identifying the dynamic load interval DLI can be if a difference of a maximum value of an integral of the current measurements I during the time interval and a minimum value of the integral of the current measurements I during the time interval is within a predetermined range. That is, the current measurements I can be integrated throughout the time interval, and the integral will assume different values throughout the time interval, among which a minimum and a maximum one. In some embodiments, the predetermined range is preferably higher than 2.5% and/or preferably lower than 5% of the battery cell capacity.

One further condition for identifying the dynamic load interval DLI can be if a value of statistical measure for dispersion of the current measurements I, preferably the standard deviation of the current measurements I, is higher than a predetermined value. In some embodiments, the predetermined value can be preferably higher than 10% of the C-rate of the battery, even more preferably higher than 25% of the C-rate of the battery.

One further condition for identifying the dynamic load interval DLI can be if an absolute value of a differential of the current measurements I reaches a predetermined threshold. In some embodiments, the predetermined threshold can preferably be higher than 1 C-rate/s.

One further condition for identifying the dynamic load interval DLI can be if an absolute value of a differential of a moving average of the current measurements I reaches a predetermined threshold. In some embodiments, the predetermined threshold can preferably be higher than 1 C-rate/s.

One further condition for identifying the dynamic load interval DLI can be if a Fourier transformation of the current measurements I results in one or more frequency peaks other than at 0 Hz.

Alternatively, or in addition, in some embodiments the dynamic load interval DLI can be defined as a time interval having a duration which can be of at least 1 minute, preferably of at least 5 minutes. That is, in some embodiments this can be considered to be a complete duration for the dynamic load interval DLI, while in some other embodiments, this can be considered to be minimum duration for the dynamic load interval DLI.

Still alternatively, or in addition, in some embodiments the dynamic load interval DLI can be defined as a time interval having a minimum duration which depends on the RC values associated to the impedance of the battery. In particular, the battery B can be modelled as having one or more RC elements, as will be described more in details in the following, and the dynamic load interval DLI can have a duration of and/or at least 1, preferably of and/or at least 5, times the biggest of the one or more RC elements. That is, in some embodiments this can be considered to be a complete duration for the dynamic load interval DLI, while in some other embodiments, this can be considered to be minimum duration for the dynamic load interval DLI. As exemplary time window W from time T1 to time T2 is illustrated, for instance, in both figures 3A and 3B.

As it can be seen in figure 3A, the relaxed voltage interval RVI is visible by the voltage signal V remaining substantially stable for a time interval prior to T1, roughly from 8.6 x 10^4 seconds to 8.62 x 10^4 seconds which, for the battery under consideration, is sufficient to determine a relaxed voltage condition. Alternatively, or in addition, as visible in figure 3B, the relaxed voltage interval RVI can be identified by the current signal I remaining substantially at 0 for a time interval prior to T1, roughly from 8.6 x 10^4 seconds to 8.62 x 10^4 seconds which, for the battery under consideration, is sufficient to determine a relaxed voltage condition.

Similarly, as it can be seen in figure 3A, the dynamic load interval DLI is visible by the voltage signal V varying outside of a predetermined range after T1, roughly from 8.62 x 10^4 seconds onward. Alternatively, or in addition, as visible in figure 3B, the dynamic load interval DLI can be identified by the current signal I complying with one or more of the criteria previously indicated.

As will become clear from the following description, the identification of a time window W starting after a relaxed voltage interval RVI of the battery B and comprising an appropriate dynamic load interval DLI of the battery B allows the dynamic component of the signals from the dynamic load interval DLI, in particular of the voltage V, to be separated from their static component.

In particular, the battery voltage V contains both a dynamic component, also known as over potential, or dynamic voltage, and a static component, also known as open circuit voltage, or static voltage. For reasons which will become clearer in the following, it is advantageous to remove the static component so as to allow the method 1000 to estimate the dynamic component. By choosing a time window W starting after a relaxed voltage interval RVI, it is possible to estimate and/or measure the static component, that is, the open circuit voltage, at the beginning of the window W and easily remove the static component from the voltage measurements V, as will be described more in details in the following description.

Moreover, for the execution of method 1000 it is advantageous to have an initial estimate of the dynamic component, that is, of the over potentials. By choosing a window W starting at the end of a relaxed voltage interval RVI, those estimates can be approximated to zero, which allows a simplified estimate procedure.

It is thus clear that the selection of the time window W based on the one or more described criteria allows data to be extracted in a particularly advantageous manner, which then allows those data to be used in a subspace identification analysis for determining battery parameters, as will become clearer in the following, such as the battery impedance. That is, from the time window W it will be possible to estimate one or more parameters of the battery B through a system identification, such as a subspace identification analysis. Those parameters can then be used to populate a model of the battery, which can in turn be used for estimating the SoC and/or SoH.

It will be clear that various techniques are possible to estimating the parameters of the battery starting from the data acquired at step S1100 followed by a subspace identification analysis, and that the invention is not specifically limited to one possible implementation. In the following, one specific example will be described, which has been deemed to be particularly advantageous, the invention is however not limited thereto.

In some embodiments the method 1000 can thus further comprise a step S1300 of determining an initial voltage, the initial voltage being the voltage measurement V at the start of the time window W. In some embodiments, particularly when the time window W is close to the end of the relaxed voltage interval RVI, the initial voltage can also correspond to the voltage measurement V at the end of the relaxed voltage interval RVI, or to an average of the voltage measurements V during the relaxed voltage interval RVI, or more generally to an open circuit voltage based on the voltage measurement V during the relaxed voltage interval RVI.

The method 1000 can, in some embodiments, further comprise a step S1400 of determining a plurality of dynamic voltages based on the voltage measurements V in the time window W and the initial voltage. Generally, as will become clearer from the following, knowledge of the initial voltage allows the determination of the dynamic component of the voltage throughout the time window W.

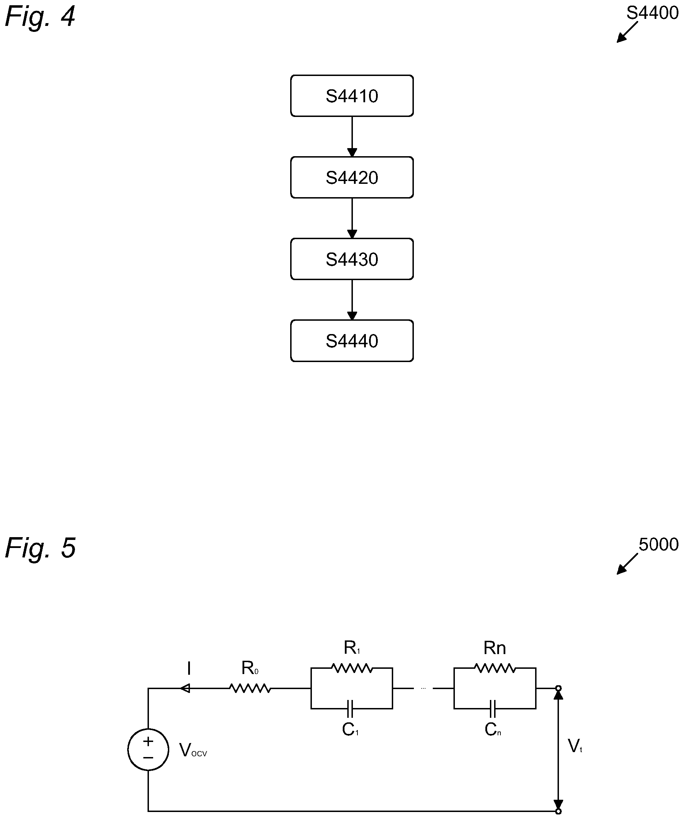

In particular, in preferred embodiments as illustrated in figure 4, the step S4400 could implement the step S1400 of determining the dynamic voltage and can comprise a step S4410 of determining an estimated initial state of charge based on the initial voltage, the estimated initial state of charge being the estimated state of charge at the start of the time window W. It will be clear to those skilled in the art that a plurality of manners are known for determining an estimated state of charge based on a voltage value. For instance, a look-up table could be used, linking the open circuit voltage and the estimated state of charge.

The state of charge can be determined at this stage based on the open circuit voltage and a model, such as a look-up table, in a reliable manner, owing to the fact that the determination is done after the relaxed voltage interval RVI.

However, when the battery is under use, the estimation of the state of charge based on the open circuit voltage becomes less precise, for instance due to sensor noise and model inaccuracies. As will be described in the following, the invention allows for a more precise manner to estimate the state of the battery even in the subsequent absence of a relaxed voltage interval RVI.

An exemplary execution of the method on the exemplary current measurements I and voltage measurements V of figures 3A and 3B can, for instance, result in an initial voltage of approximately 4,072V which, for the exemplary battery under consideration, corresponds to an estimated initial state of charge of approximately 86,4%, as derived from a model, such as a look-up-table.

The step S4400 could further comprise a step S4420 of determining a plurality of estimated states of charge throughout the time window W based on the estimated initial state of charge. Also in this case, it will be clear to those skilled in the art that a plurality of approaches are known for estimating the evolution of the state of charge of a battery based on a known initial state of charge. For instance, the estimated of charge at any given time throughout the time window can be obtained by adding the integral value of the current measurement I to the initial state of charge.

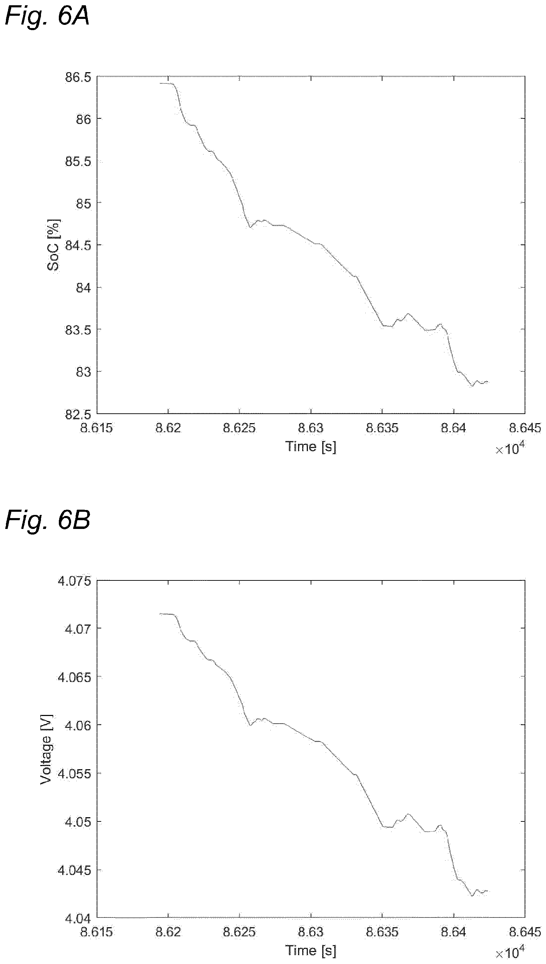

Referring back to the exemplary execution indicated above, figure 6A shows an exemplary evolution of the estimated states of charge throughout the time window W. In this example, the estimated states of charge substantially decrease throughout the time window W.

The step S4400 could further comprise a step S4430 of determining a plurality of estimated open circuit voltages throughout the time window W based on the estimated plurality of states of charge. As previously discussed, various manners such as a look-up table could be implemented for the conversion.

Referring back to the exemplary execution indicated above, figure 6B shows an exemplary evolution of the estimated open circuit voltages throughout the time window W.

The step S4400 could then further comprise a step S4440 of determining the plurality of dynamic voltages as, at any given time throughout the time window W, a difference between the voltage measurement V and the respective estimated open circuit voltage at the given time. In this manner, at any given time, the static component of the voltage measurement V is removed from the voltage measurement V thus leaving only the dynamic component.

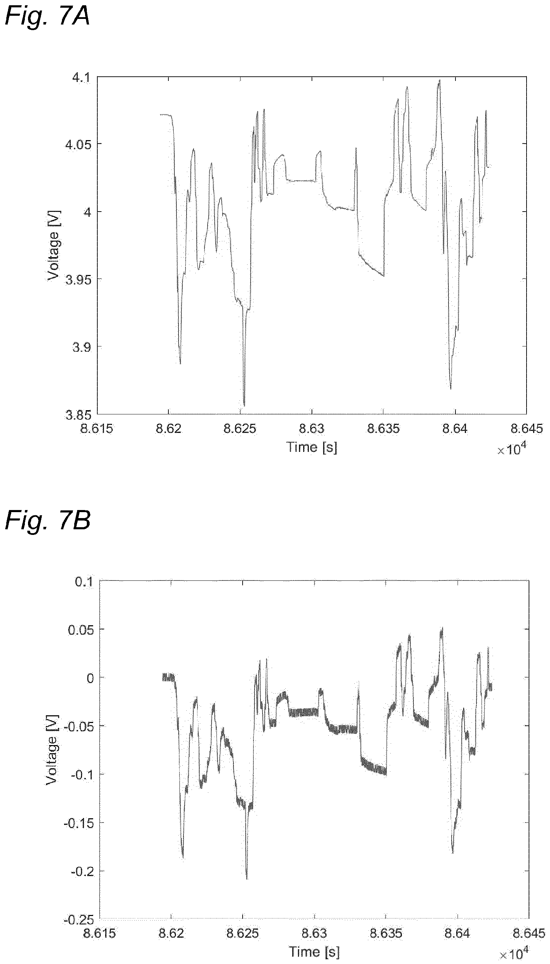

Referring back to the exemplary execution indicated above, figure 7A shows an enlarged portion of the voltage measurements of the time window W, approximately from $8{,}615 \times 10^4$ seconds to $8{,}645 \times 10^4$ seconds.

Similarly, figure 7B shows the dynamic voltage during the time window, obtained by the difference between the voltage measurements V and the static component, that is, the estimated open circuit voltages.

With this approach it is thus possible to extract the dynamic component from the respective voltage measurements V at any point in time of the time window W with a simple and reliable manner. It will however be clear that alternative manners could be implemented for extracting the dynamic component from the respective voltage measurements V and the invention is not to be limited to the specific implementation illustrated in figure 4. In general, the purpose of step S1400 is to obtain a plurality of dynamic voltages, that is, the dynamic component of the voltage measurements V, throughout the time window W based on the knowledge of the initial voltage.

Alternatively, in some embodiments, the open circuit voltage throughout the dynamic load interval DLI can be alternatively considered to be substantially constant, particularly if the dynamic load interval DLI is selected so that the integral of the absolute value of the current measurements during the dynamic load interval DLI is lower than a predetermined threshold. This approach has the advantage that it is not necessary to determine a plurality of open circuit voltages throughout the dynamic load interval DLI but a single value can be used, thus simplifying the method.

The method 1000 further comprises a step S1500 of executing a subspace identification analysis within the time window W, for estimating one or more parameters of the battery. In some preferred embodiments, the subspace identification analysis can be based on the plurality of current measurements I and on the plurality of dynamic voltages. In some preferred embodiments, the one or more parameters can comprise one or more time constants of one or more respective RC components of a model of the battery, as will be described in the following. Alternatively, or in addition, in some preferred embodiments, the one or more parameters can comprise one or more resistance values of one or more respective RC components of the model and/or an ohmic resistance value of the model. Still alternatively, or in addition, in some preferred embodiments, the one or more parameters can comprise one or more capacitance values of one or more respective RC components of the model. As will be described in the following, the one or more parameters can be expressed as a function of the state of the battery, preferably as a function of the state of charge SoC of the battery.

Subspace identification analysis are known manners for, knowing various measurements of a given system, at various time instants, determining a state of variables of the system which cannot be directly measured. In the case of the method 1000, in general, the subspace identification analysis can be used to determine the value of parameters of the battery B based on the plurality of current measurements I and on the plurality of dynamic voltages. In particular, in preferred embodiments, the subspace identification analysis can be performed with the plurality of current measurements I as input and the plurality of dynamic voltages as output.

Various techniques are known for performing a subspace identification analysis. For explanatory purposes, in the following one possible implementation will be described for identifying the battery impedance as unknown parameter. It will however be clear that the invention is not limited thereto.

In some preferred embodiments, the subspace identification analysis can be based on a state-space representation of the type of

$$X_k = A \cdot X_{K-1} + B \cdot U_K$$

$$Y_k = C \cdot X_K$$

wherein

- k and k-1 represent a time instants of the time window W,
- k represents a time instant subsequent to k-1, in some embodiments, the distance in time between k-1 and k can correspond to the distance in time between sampling points for the current measurements I and/or for the voltage measurements V
- $X_k$ represents a state vector at time k,
- $U_k$ represents a current measurement I, at time k,
- $Y_k$ represents a value of the terminal voltage measured at the battery, at time k,
- A represents a state matrix, also known as system matrix,
- B represents a control matrix,
- C represents an output matrix.

In the following, an example using this implementation with N indicating the total number of data points in the time window W will be discussed.

The state vector X can be expressed as a matrix have one column and a number of rows which depends on the number P of RC elements, or poles, of the battery B. That is, the impedance of the battery B can be described by a function having a number of poles P, or an equivalent RC circuit, having a number P of RC elements. In some embodiments, the number of poles P is at least 1, preferably 2, even more preferably 3. With a generic number of poles P, the state vector x can be described as:

$$X_k = \begin{pmatrix} V_{RC_{1,k}} \\ \dots \\ V_{RC_{P,k}} \\ SoC_k \\ V_{R_0,k} \end{pmatrix}$$

where:

- $V_{RC1,k}$ corresponds to the voltage across a first RC element, at time k,
- $V_{RCP,k}$ corresponds to the voltage across a $P^{th}$ RC element, at time k,
- $SoC_k$ corresponds to the state of charge, at time k,
- $V_{R0,k}$ corresponds to the voltage across an ohmic resistor of the battery, resistor $R_0$, at time k.

That is, P rows in the state vector X can comprise the dynamic potential of the given RC element, one row can comprise the state of charge and one row can comprise the potential across the ohmic resistor. For instance, in case of a battery B modelled by a function having has two poles, thus P=2, the state vector can be expressed as

$$X_k = \begin{pmatrix} V_{RC_{1,k}} \\ V_{RC_{2,k}} \\ SoC_k \\ V_{R_0,k} \end{pmatrix}$$

where $V_{RC1,k}$ corresponds to the dynamic potential of a first RC element at time k, and $V_{RC2,k}$ corresponds to the dynamic potential of a second RC element at time k.

The state matrix A can be a diagonal matrix with a number of rows equal to the number of poles P+2. The diagonal elements being multiplied with the potentials of the RC elements correspond to the time constant of the respective RC element, while the diagonal element corresponding to the state of charge element can be set to 1 and the diagonal element corresponding to the ohmic resistance can be set to 0.

For instance, based on the state vector X indicated above, the state matrix A can be described as:

$$A = \begin{pmatrix} e^{-\frac{\Delta t}{\tau_1}} & 0 & 0 & 0 \\ 0 & e^{-\frac{\Delta t}{\tau_2}} & 0 & 0 \\ 0 & 0 & 1 & 0 \\ 0 & 0 & 0 & 0 \end{pmatrix}$$

where $\tau_1$ corresponds to the time constant of the first RC element and $\tau_P$ corresponds to the time constant of the $P^{th}$ RC element. That is, for a given time constant $\tau$, the time constant can be defined as

$$\tau_n = R_n * C_n.$$

Additionally, $\Delta t$ indicates time, preferably the amount of time between two consecutive sampled points in the time window W.

The control matrix B can then be expressed as a matrix having one column and P+2 rows. In the control matrix B, rows corresponding to the $n^{th}$ dynamic potential of the state vector X can be defined as

$$R_n \left( 1 - e^{-\frac{\Delta t}{\tau_n}} \right)$$

where $R_n$ represent the resistance of the respective $n^{th}$ RC element.

The row corresponding to the state of charge of the state vector X can be defined as

$$\frac{\Delta t}{C_N}$$

where $C_N$ is the capacity of the battery, which is assumed to be known.

Finally, the row corresponding to the voltage across an ohmic resistor of the state vector X can be defined as $R_0$, namely as the value of the ohmic resistor.

For instance, based on the state vector X indicated above, the control matrix B can be described as:

$$B = \begin{pmatrix} R_1 \left( 1 - e^{-\frac{\Delta t}{\tau_1}} \right) \\ R_2 \left( 1 - e^{-\frac{\Delta t}{\tau_2}} \right) \\ \frac{\Delta t}{C_N} \\ R_0 \end{pmatrix}$$

The output matrix C can be expressed as a matrix having one row and P+2 columns, where the columns corresponding to the $n^{th}$ dynamic potential of the state vector X can be defined as substantially equal to 1. The column corresponding to the state of charge of the state vector X can be defined as

$$\frac{\delta OCV}{\delta SoC}$$

Where $\delta OCV$ corresponds to a variation of OCV between k-1 and k, and $\delta SoC$ corresponds to a variation of SoC between k-1 and k.

Finally, the column corresponding to the voltage across an ohmic resistor of the state vector X can be defined as substantially equal to 1.

For instance, based on the state vector X indicated above, the output matrix C can be described as:

$$C = \begin{pmatrix} 1 & 1 & \frac{\delta OCV}{\delta SoC} & 1 \end{pmatrix}$$

In the above equations all the parameters values can be measured or derived from the voltage and current data acquired at step S1100, except values of $R_0$, $R_1$-$R_P$, and

$$\tau_1 - \tau_P.$$

Those parameters can be obtained from the subspace identification analysis as a function of the state of charge SoC. It will be clear that from the value of the time constant

$$\tau_n = C_n * R_n$$

and of the respective resistance $R_n$, the value of the capacitance $C_n$ can be easily computed too.

Various subspace identification methods are known by the skilled person and can be implemented for obtaining the unknown parameters. Preferably, subspace identification methods defined for a combination of stochastic and deterministic system can be used. One example implementation can be found for instance in chapter 6.1 of "Subspace Identification for Linear Systems Theory - Implementation - Applications" Peter Van Overschee / Bart De Moor, for instance in page 169 of the publication year 1996.

As an example, it is possible to compute the eigenvector of the state matrix A and thus obtain the time constants

$$(T_1 - T_P)$$

of the RC elements of the battery B. The remaining unknown in the state equation found in the B matrix, namely $R_1 - R_P$, can then be computed by solving the state equation using linear algebra.

Moreover, in some preferred embodiments, the subspace identification analysis can comprise a step of orthogonal projection of respectively block Hankel matrix of the current measurements I acquired at step S1100 and of the dynamic voltages obtained from step S1400, S4400. The orthogonal projection advantageously allows noise to be projected out from the states.

In particular, the input Hankel matrix of the current measurements I can be defined as:

$$U_{0|2i-1} = \begin{bmatrix} u[0] & u[1] & \cdots & u[M-1] \\ u[1] & u[2] & \ldots & u[M] \\ \vdots & \vdots & \vdots & \vdots \\ u[i-1] & u[i] & \cdots & u[i+M-2] \\ u[i] & u[i+1] & \ldots & u[i+M-1] \\ u[i+1] & u[i+2] & \ldots & u[i+M] \\ \vdots & \vdots & \vdots & \vdots \\ u[2*i-1] & u[2*i] & \ldots & u[2*i+M-2] \end{bmatrix}$$

$$= \begin{bmatrix} U_{0|i-1} \\ U_{i|2i-1} \end{bmatrix}$$

$$= \begin{bmatrix} U_p \\ U_f \end{bmatrix}$$

where;

- i is a value greater than P, preferably i = 2*P, or greater, where P is the number of poles of the battery B as previously described,
- N is the total number of data points in the window
- M = N+1-(2*i)

Similarly, the output Hankel matrix of the dynamic voltages V can be defined as:

$$Y_{0|2i-1} = \begin{bmatrix} y[0] & y[1] & \cdots & y[M-1] \\ y[1] & y[2] & \cdots & y[M] \\ \vdots & \vdots & \vdots & \vdots \\ y[i-1] & y[i] & \cdots & y[i+M-2] \\ y[i] & y[i+1] & \cdots & y[i+M-1] \\ y[i+1] & y[i+2] & \cdots & y[i+M] \\ \vdots & \vdots & \vdots & \vdots \\ y[2*i-1] & y[2*i] & \cdots & y[2*i+M-2] \end{bmatrix}$$

$$= \begin{bmatrix} Y_{0|i-1} \\ Y_{i|2i-1} \end{bmatrix}$$

$$= \begin{bmatrix} Y_p \\ Y_f \end{bmatrix}$$

Here it is noted that the formal distinction in past components, namely $U_p$ and $Y_p$, and future components namely $U_f$ and $Y_f$, is arbitrary since all the data in the matrices are already measured and available.

Moreover, in some preferred embodiments, the subspace identification analysis can comprise a step of oblique projection of respectively the computed orthogonal projections of the block Hankel matrix of the current measurements I and of the dynamic voltages. The oblique projection advantageously allows to obtain filtered observability matrix.

Moreover, in some preferred embodiments, the subspace identification analysis can further comprise a step of singular vector decomposition to obtain the system matrix A. In particular, using as input for the singular vector decomposition the output of the oblique projection of orthogonally projected block Hankel matrix an/or of the oblique projection of orthogonally projected block Hankel matrix, it is possible using linear algebra to compute the value of the observability matrix $O_i$, which comprises the system matrix A. From the system matrix A it is possible to obtain the impedance value from the system matrix. Alternatively, or in addition, in some embodiments the singular vector decomposition might use as input the output of the orthogonal projection of block Hankel matrix and/or of the orthogonal projection of block Hankel matrix instead. Still alternatively, or in addition, the for the singular vector decomposition might use as input the output of step S1400, S4400.

That is, summarizing, the output of step S1500 can provide the eigenvector of the system matrix A. Computing the eigenvalues of the output of subspace can calculate the values of the exponential terms of the system matrix A, for instance, for a two pole system, $\tau_1$ and $\tau_2$. Those exponential terms can be calculated using the sampling time and natural logarithm. Once the exponential terms are known, the unknown resistors, namely $R_0$, $R_1$-$R_P$, occur linearly in the system matrix equations. The values of $R_0$, $R_1$-$R_P$ can thus be computed by solving the dynamic voltage of the window with respect to the current measurement, using for instance a linear least squares method. This provides then values of $R_0$, $R_1$-$R_P$,

$$\tau_1\text{-}\tau_P.$$

Thanks to the one or more parameters computed at step S1500 it is possible implement a step S1600 of populating a model of the battery B with the one or more parameters. This is particularly advantageous as the model does not therefore need to be created and/or populated based on a characterization of the battery B in a laboratory, but can be populated based on the one or more battery parameters obtained as indicated.

Figure 5 schematically illustrates an exemplary graphical illustration of a model 5000 of a battery. The model 5000 is a n-RC model, in that it comprises any number n of RC groups. It will be clear that the model 5000 is illustrated in the graphical form for clarity of illustration and for simplicity in explaining the various parameters and the operation of the invention. In practical implementations, the model 5000 can be implemented in other forms, for instance as a look-up-table or more generally as a data structure with a plurality of stored values such that applying an input to the plurality of stored values results in a corresponding output.

Model 5000 comprises the following parameters:

- Vocv representing the open circuit voltage;
- $R_0$ representing the ohmic resistance;
- one or more RC groups, such as the group formed by $R_1$ and $C_1$, $R_n$ and $C_n$, each comprising a resistance and a capacitance;
- I representing an input current;
- Vt representing an output voltage, or the terminal voltage at the battery terminals.

Model 5000 can be used with the current I as input and with the terminal Voltage Vt as output. Field data can be measured from a battery B for which the model 5000 is to be created. For instance, the field data can comprise the current and/or the voltage data measured at step S1100.

As described above, the parameters in the model 5000, in particular any of $R_0$, $R_1$-$R_n$, $C_1$-$C_n$ can be obtained as function of the state of charge of the battery B. A Look-up-table can therefore be constructed, between any of those parameters versus the state of charge SoC. This can be used as the finalized model.

In particular, in some embodiments, at least the step S1500 of executing the subspace identification analysis can be executed a plurality of time, for a plurality of different values of the state of charge SoC of the battery.

In some embodiments, this can be implemented by choosing, for the execution of the subspace identification analysis, different time windows W starting after different relaxed voltage intervals RVI, corresponding to different states of charge SoC. It will be thus clear that, in addition to the plurality of execution of step S1500, any of steps S1100-S1400 can be executed a plurality of times.

It will be further clear that not all steps S1100-S1500 need to be executed the same number of times. For instance, while step S1100 could be executed only once, the step S1200-S1500 could each be executed a plurality of times based on the data obtained by the single execution of step S1100.

In some embodiments, the step S1600 of populating the model 5000 of the battery B can thus comprise populating a look-up table as a function of the different values of the state of charge. In particular, the look-up table can comprise any of the parameters of the model 5000, and more generally any combination of the parameters $R_0$, $R_1$-$R_n$, $C_1$-$C_n$,

$$\tau_1-\tau_n,$$

as a function of the different values of the state of charge.

Still in other words, the model 5000 can comprise a first set S1 of any of the parameters $R_0$, $R_1$-$R_n$, $C_1$-$C_n$,

$$\tau_1-\tau_n,$$

for a given first state of charge, and a second set S1 of any of the parameters $R_0$, $R_1$-$R_n$, $C_1$-$C_n$,

$$\tau_1-\tau_n,$$

for a given second state of charge.

This enables the creation of a model 5000 which can be used to determine the state of charge SoC when the remaining parameters of the model are known. The method 1000 can thus further comprise a step S1800 of estimating the state of the battery B, for instance the SoC and/or the SoH, based on the model 5000.

That is, after the creation of the model 5000, the parameters expressed as a function of the state of charge in the model 5000 can be measured and/or derived from values measured from the battery. For instance, one or more parameters can be derived with known methods and/or with a new the execution of step S1500, and possibly a new execution of corresponding steps S1100-S1440. Once the parameters expressed as a function of the state of charge in the model 5000 are known, they can be inputted in the model 5000 so as to extract the corresponding value of the state of charge SoC. From the state of charge SoC it is thus possible to derive the state of the battery B, this the state of charge SoC itself of the state of health SoH, which can be derived from the state of charge SoC in known manners.

The method further comprises a step S1700 of executing a Kalman filter on the model 5000 of the battery B. The Kalman filter can be understood as a recursive algorithm which uses the already parameterized model 5000.

As an example, using the same state-space previously described, there might be cases in which the state-space comprises process noise and/or measurement noise, as indicated below

$$X_k = A \cdot X_{k-1} + B \cdot U_k + \omega_k$$

$$Y_k = C \cdot X_k + D \cdot U_k + \upsilon_k$$

where the parameters $w_k$ and $v_k$ indicate the process noise and measurement noise respectively. The execution of the Kalman filter generally allows filtering these noises out. As a consequence a correction of the states occur. In particular, since the state of charge SoC is part of the states, the execution of the Kalman filter allows the determination of the state of charge, and/or the determination of the other parameters as a function of the state of charge, to be performed with higher accuracy.

It will be clear to those skilled in the art that, although step S1700 is illustrated after step S1600, step S1700 can be implemented on the states computed for step S1500, at the same time of execution of step S1500. Alternatively, or in addition, step S1700 can be implemented on the states and/or on the parameters outputted by step S1500, prior to populating the model 5000. Still alternatively, or in addition, the step S1700 can be implemented on the model 5000.

The description above has been provided with respect to a method. The invention is however not limited to being implemented as a method. In particular, as visible in figure 2, the invention can also be implemented by an apparatus 2000 for estimating a state of a battery B. In particular, the apparatus can comprise a memory 2200 and a processor 2300, wherein the memory 2200 comprises instructions configured to, when executed, cause the processor 2300 to carry out any of the steps previously described.

Preferably, the apparatus 2000 can further comprise communication means 2100 for obtaining the plurality of voltage measurements V and the plurality of current measurements I. In the embodiment illustrated in figure 2, the plurality of voltage measurements V and the plurality of current measurements I can be obtained by, respectively, a voltage meter VM and a current meter IM. The communication means 2100 could communicate directly with one or more of the voltage meter VM and the current meter IM. Alternatively, or in addition, one or more of the voltage meter VM and the current meter IM could communicate with a further entity, for instance a controller of the battery B, which could then communicate the measurements to the communication means 2100.

This advantageously allows the apparatus 2000 t perform the method on a battery B remotely located simply by using the voltage meter VM and the current meter IM connected to the battery B and/or to the load L. It will be clear that the acquiring step S1100 can be similarly performed through communication means 2100 so that the method can be similarly executed on a battery B remotely located.

Similarly, the invention can be implemented as any of a software, a computer program, a computer-program product, a computer-readable storage medium including program code, which, when executed on a processor 2300, causes the processor 2300 to carry out any of the steps previously described.

It is to be understood that the features mentioned above may be used not only in the respective combinations indicated, but also in other combinations or in isolation without departing from the scope of the invention as defined by the claims.

**List of reference numerals**

    1000: method for estimating an impedance of a battery
    S1100: voltage and current data acquisition
    S1200: time window identification
    S1300: open circuit voltage determination
    S1400: dynamic voltage determination
    S1500: subspace identification analysis execution
    S1600: model population
    S1700: Kalman filtering
    S1800: state estimation
    2000: apparatus for estimating an impedance of a battery
    2100: communication means
    2200: memory
    2300: processor
    B: battery
    IM: current meter
    VM: voltage meter

L: load
T1, T2: time
I: current measurement
V: voltage measurement
RVI: relaxed voltage interval
DLI: dynamic load interval
S4400: dynamic voltage determination
S4410: estimated initial state of charge determination
S4420: plurality of estimated states of charge determination
S4430: plurality of estimated open circuit voltages determination
S4440: plurality of dynamic voltages determination
5000: model

**Claims**

1. A method (1000) for estimating a state of a battery (B), the method comprising the steps of:

   acquiring (S1100) data of the battery (B) during at least a predetermined time range, the data comprising at least a plurality of voltage measurements (V) and a plurality of current measurements (I),
   determining (S1200) a time window (W) within the predetermined time range, the time window (W) starting after a relaxed voltage interval (RVI) and comprising a dynamic load interval (DLI),
   executing a subspace identification analysis (S1500) within the time window (W) resulting in the determination of one or more parameters of the battery (B),
   populating (S1600) a model (5000) of the battery (B) with the one or more parameters,
   estimating (S1800) the state of the battery based on the model (5000),
   **characterized in that** the method further comprises a step of executing a Kalman filter (S1700) on the model of the battery (B).

2. The method according to claim 1,
   wherein the one or more parameters comprise one or more time constants of one or more respective RC components of the model (5000).

3. The method according to claim 1 or 2,
   wherein the one or more parameters comprise one or more resistance values ($R_1$ - $R_n$) of one or more respective RC components ($R_1$, $C_1$ - $R_n$, $C_n$) of the model (5000) and/or an ohmic resistance value ($R_0$) of the model (5000).

4. The method according to any of claims 1 to 3,
   wherein the one or more parameters comprise one or more capacitance values ($C_1$ - $C_n$) of one or more respective RC components ($R_1$, $C_1$ - $R_n$, $C_n$) of the model (5000).

5. The method according to any of claims 1 to 4, wherein the one or more parameters are expressed as a function of the state of the battery.

6. The method according to any previous claim,

   wherein at least the step of executing the subspace identification analysis (S1500) is executed a plurality of time, for a plurality of different values of the state of charge of the battery (B),
   and wherein the step of populating (S1600) the model (5000) of the battery (B) comprises populating a look-up table as a function of the different values of the state of charge.

7. An apparatus (2000) for estimating a state of a battery (B), the apparatus comprising a memory (2200) and a processor (2300),
   wherein the memory (2200) comprises instructions configured to, when executed, cause the processor (2300) to carry out the steps of any previous claim.

8. The apparatus (2000) according to claim 7 further comprising communication means (2100) for obtaining the plurality of voltage measurements (V) and the plurality of current measurements (I).

9. A software which, when executed on a processor (2300), causes the processor (2300) to carry out any of the steps of any of claims 1-6.

**Patentansprüche**

1. Verfahren (1000) zum Schätzen eines Zustands einer Batterie (B), wobei das Verfahren die folgenden Schritte umfasst:

   Erfassen (S1100) von Daten der Batterie (B) während mindestens eines vorbestimmten Zeitbereichs, wobei die Daten mindestens mehrere Spannungsmessungen (V) und mehrere Strommessungen (I) umfassen,
   Bestimmen (S1200) eines Zeitfensters (W) innerhalb des vorbestimmten Zeitbereichs, wobei das Zeitfenster (W) nach einem relaxierten Spannungsintervall (RVI) beginnt und ein dynamisches Lastintervall (DLI) umfasst,
   Ausführen einer Teilraumidentifikationsanalyse (S1500) innerhalb des Zeitfensters (W), was zu der Bestimmung von einem oder mehreren Parametern der Batterie (B) führt,
   Populieren (S1600) eines Modells (5000) der Batterie (B) mit dem einen oder den mehreren Parametern,
   Schätzen (S1800) des Zustands der Batterie auf Basis des Modells (5000),
   **dadurch gekennzeichnet, dass** das Verfahren weiter einen Schritt des Ausführens eines Kalman-Filters (S1700) an dem Modell der Batterie (B) umfasst.

2. Verfahren nach Anspruch 1,
   wobei der eine oder die mehreren Parameter eine oder mehrere Zeitkonstanten einer oder mehrerer jeweiliger RC-Komponenten des Modells (5000) umfassen.

3. Verfahren nach Anspruch 1 oder 2,
   wobei der eine oder die mehreren Parameter einen oder mehrere Widerstandswerte ($R_1$ - $R_n$) einer oder mehrerer jeweiliger RC-Komponenten ($R_1$, $C_1$ - $R_n$, $C_n$) des Modells (5000) und/oder einen ohmschen Widerstandswert ($R_0$) des Modells (5000) umfassen.

4. Verfahren nach einem der Ansprüche 1 bis 3,
   wobei der eine oder die mehreren Parameter einen oder mehrere Kapazitätswerte ($C_1$ - $C_n$) einer oder mehrerer jeweiliger RC-Komponenten ($R_1$, $C_1$ - $R_n$, $C_n$) des Modells (5000) umfassen.

5. Verfahren nach einem der Ansprüche 1 bis 4, wobei der eine oder die mehreren Parameter als eine Funktion des Zustands der Batterie ausgedrückt werden.

6. Verfahren nach einem vorhergehenden Anspruch,

   wobei mindestens der Schritt des Ausführens der Teilraumidentifikationsanalyse (S1500) mehrmals für mehrere verschiedene Werte des Ladezustands der Batterie (B) ausgeführt wird,
   und wobei der Schritt des Populierens (S1600) des Modells (5000) der Batterie (B) das Populieren einer Nachschlagetabelle als Funktion der verschiedenen Werte des Ladezustands umfasst.

7. Vorrichtung (2000) zum Schätzen eines Zustands einer Batterie (B), wobei die Vorrichtung einen Speicher (2200) und einen Prozessor (2300) umfasst,
   wobei der Speicher (2200) Anweisungen umfasst, die ausgelegt sind, um bei Ausführung zu bewirken, dass der Prozessor (2300) die Schritte eines beliebigen vorausgegangenen Anspruchs ausführt.

8. Vorrichtung (2000) nach Anspruch 7, weiter umfassend ein Kommunikationsmittel (2100) zum Erhalten der mehreren Spannungsmessungen (V) und der mehreren Strommessungen (I) .

9. Software, die bei Ausführung auf einem Prozessor (2300) bewirkt, dass der Prozessor (2300) einen beliebigen der Schritte nach einem der Ansprüche 1-6 ausführt.

**Revendications**

1. Procédé (1000) d'estimation de l'état d'une batterie (B), le procédé comprenant les étapes suivantes :

acquérir (S1100) des données de la batterie (B) pendant au moins une plage de temps prédéterminée, les données comprenant au moins une pluralité de mesures de tension (V) et une pluralité de mesures de courant (I), déterminer (S1200) une fenêtre temporelle (W) dans la plage de temps prédéterminée, la fenêtre temporelle (W) commençant après un intervalle de tension détendu (RVI) et comprenant un intervalle de charge dynamique (DLI),

exécuter une analyse d'identification de sous-espace (S1500) dans la fenêtre temporelle (W) résultant en la détermination d'un ou plusieurs paramètres de la batterie (B),

alimenter (S1600) un modèle (5000) de la batterie (B) avec les un ou plusieurs paramètres,

estimer (S1800) l'état de la batterie sur la base du modèle (5000),

le procédé étant **caractérisé en ce qu'**il comprend en outre une étape d'exécution d'un filtre de Kalman (S1700) sur le modèle de la batterie (B).

2.  Procédé selon la revendication 1, dans lequel les un ou plusieurs paramètres comprennent une ou plusieurs constantes de temps d'un ou plusieurs composants RC respectifs du modèle (5000).

3.  Procédé selon la revendication 1 ou la revendication 2, dans lequel les un ou plusieurs paramètres comprennent une ou plusieurs valeurs de résistance ($R_1$ - $R_n$) d'un ou plusieurs composants RC respectifs ($R_1$, $C_1$ - $R_n$, $C_n$) du modèle (5000) et/ou une valeur de résistance ohmique ($R_0$) du modèle (5000).

4.  Procédé selon l'une quelconque des revendications 1 à 3,
    dans lequel les un ou plusieurs paramètres comprennent une ou plusieurs valeurs de capacité ($C_1$ -$C_n$) d'un ou plusieurs composants RC respectifs ($R_1$, $C_1$ - $R_n$, $C_n$) du modèle (5000).

5.  Procédé selon l'une quelconque des revendications 1 à 4, dans lequel les un ou plusieurs paramètres sont exprimés en fonction de l'état de la batterie.

6.  Procédé selon l'une quelconque des revendications précédentes,

    dans lequel au moins l'étape d'exécution de l'analyse d'identification du sous-espace (S1500) est exécutée plusieurs fois, pour plusieurs valeurs différentes de l'état de charge de la batterie (B),
    et où l'étape de remplissage (S1600) du modèle (5000) de la batterie (B) comprend le remplissage d'une table de consultation en fonction des différentes valeurs de l'état de charge.

7.  Appareil (2000) d'estimation de l'état d'une batterie (B), l'appareil comprenant une mémoire (2200) et un processeur (2300),
    où la mémoire (2200) comprend des instructions configurées pour, lorsqu'elles sont exécutées, amener le processeur (2300) à effectuer les étapes selon l'une quelconque des revendications précédentes.

8.  Appareil (2000) selon la revendication 7, comprenant en outre des moyens de communication (2100) pour obtenir la pluralité de mesures de tension (V) et la pluralité de mesures de courant (I).

9.  Logiciel qui, lorsqu'il est exécuté sur un processeur (2300), amène le processeur (2300) à exécuter l'une quelconque des étapes de l'une quelconque des revendications 1 à 6.

## Fig. 1

1000

| Voltage and current data acquisition | S1100 |
| Time window identification | S1200 |
| Open circuit voltage determination | S1300 |
| Dynamic voltage determination | S1400 |
| Subspace identification analysis | S1500 |
| Model population | S1600 |
| Kalman filter | S1700 |
| Estimating battery state | S1800 |

## Fig. 2

2000

*Fig. 3A*

18

Fig. 3B

*Fig. 4*                                                                      S4400

```
┌─────────────┐
│   S4410     │
└─────────────┘
       │
       ▼
┌─────────────┐
│   S4420     │
└─────────────┘
       │
       ▼
┌─────────────┐
│   S4430     │
└─────────────┘
       │
       ▼
┌─────────────┐
│   S4440     │
└─────────────┘
```

*Fig. 5*                                                                      5000

*Fig. 6A*

*Fig. 6B*

*Fig. 7A*

*Fig. 7B*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016016482 A1

**Non-patent literature cited in the description**

- Sequential Monte Carlo Filter for State-of-Charge Estimation of Lithium-Ion Batteries Based on Auto Regressive Exogenous Model. **DONG GUANGZHONG et al.** IEEE TRANSACTIONS ON INDUSTRIAL ELECTRONICS. IEEE SERVICE CENTER, 01 November 2019, vol. 66

- Subspace Identification for Linear Systems Theory - Implementation - Applications. *Peter Van Overschee / Bart De Moor,* 169